# EUROPEAN PATENT APPLICATION

(11) **EP 4 155 821 A1**
(43) Date of publication of application: **29.03.2023**
(21) Application number: 21199182.3
(22) Date of filing: 27.09.2021
(51) Int. Cl.: G03F 7/20

(54) **METHOD FOR FOCUS METROLOGY AND ASSOCIATED APPARATUSES**

(71) Applicant: ASML Netherlands B.V., 5500 AH Veldhoven (NL)
(72) Inventor: VAN LARE, Marie-Claire, 5500 AH Veldhoven (NL); OP 'T ROOT, Wilhelmus, Patrick, Elisabeth, Maria, 5500 AH Veldhoven (NL)
(74) Representative: ASML Netherlands B.V.

(57) **Abstract**

Disclosed is a method for determining a focus parameter from a target on a substrate. The target comprises an isofocal first sub-target and a second non-isofocal sub-target. The method comprises obtaining a first measurement signal relating to measurement of the first sub-target, a second measurement signal relating to measurement of the second sub-target and at least one trained relationship and/or model which relates at least said second measurement signal to said focus parameter. A value for said focus parameter is determined from said first measurement signal, second measurement signal and said at least one trained relationship and/or model.

## Description

### FIELD

The present invention relates to metrology applications in the manufacture of integrated circuits.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Metrology tools are used in many aspects of the IC manufacturing process, for example as alignment tools for proper positioning of a substrate prior to an exposure and scatterometry based tools for inspecting/measuring the exposed and/or etched product in process control; e.g., to measure overlay.

One important parameter of a lithographic process which requires monitoring is focus. There is a desire to integrate an ever-increasing number of electronic components in an IC. To realize this, it is necessary to decrease the size of the components and therefore to increase the resolution of the projection system, so that increasingly smaller details, or line widths, can be projected on a target portion of the substrate. As the critical dimension (CD) in lithography shrinks, consistency of focus, both across a substrate and between substrates, becomes increasingly important. CD is the dimension of a feature or features (such as the gate width of a transistor) for which variations will cause undesirable variation in physical properties of the feature. Traditionally, optimal settings were determined by "send-ahead wafers" i.e. substrates that are exposed, developed and measured in advance of a production run. In the send-ahead wafers, test structures are exposed in a so-called focus-energy matrix (FEM) and the best focus and energy settings are determined from examination of those test structures.

Another method of determining focus and/or dose has been through diffraction based focus techniques. Diffraction based focus may use target forming features on the reticle which print targets having a degree of asymmetry which is dependent on the focus and/or dose setting during printing. This degree of asymmetry can then be measured and the focus and/or dose inferred from the asymmetry measurement. Such focus measuring methods, and the associated test structure designs have a number of drawbacks. Many test structures require subresolution features or grating structures with large pitches. Such structures may contravene design rules of the users of lithographic apparatuses. Focus measuring techniques may comprise measuring asymmetry in opposite higher (e.g., first) order radiation scattered by special, focus dependent, target structures and determining focus from this asymmetry.

It would be desirable to improve on present focus metrology techniques.

### SUMMARY

In a first aspect of the invention there is provided a method for determining a focus parameter from a target on a substrate, the target comprising at least a first sub-target and second sub-target, said focus parameter relating to a focus setting of a lithographic exposure process in which said target was exposed; the method comprising: obtaining a first measurement signal relating to measurement of the first sub-target, said first sub-target comprising an isofocal structure; obtaining a second measurement signal relating to measurement of the second sub-target, said second sub-target comprising an non-isofocal structure; obtaining at least one trained relationship and/or model which relates at least said second measurement signal to said focus parameter; and determining a value for said focus parameter from said first measurement signal, second measurement signal and said at least one trained relationship and/or model.

In a second aspect of the invention there is provided a patterning device comprising target patterning features for forming a target, the target patterning features comprising: isofocal patterning features for forming a first sub-target such that it comprises an isofocal structure; and non-isofocal patterning features for forming a second sub-target such that it comprises a non-isofocal structure.

The invention yet further provides a computer program product comprising machine-readable instructions for causing a processor to perform the method of the first aspect, and associated metrology apparatus and lithocell.

The above and other aspects of the invention will be understood from a consideration of the examples described below.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, for use in methods according to embodiments of the invention;
- Figure 5 comprises (a) a schematic diagram of a pupil and dark field scatterometer for use in methods according to embodiments of the invention using a first pair of illumination apertures, and (b) a detail of diffraction spectrum of a target grating for a given direction of illumination;
- Figure 6 is a schematic representation of a focus target according to an embodiment of the invention; and
- Figure 7 is shows plots of CD against defocus for an isofocal sub-target and non-isofocal sub-target of the target of Figure 6.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

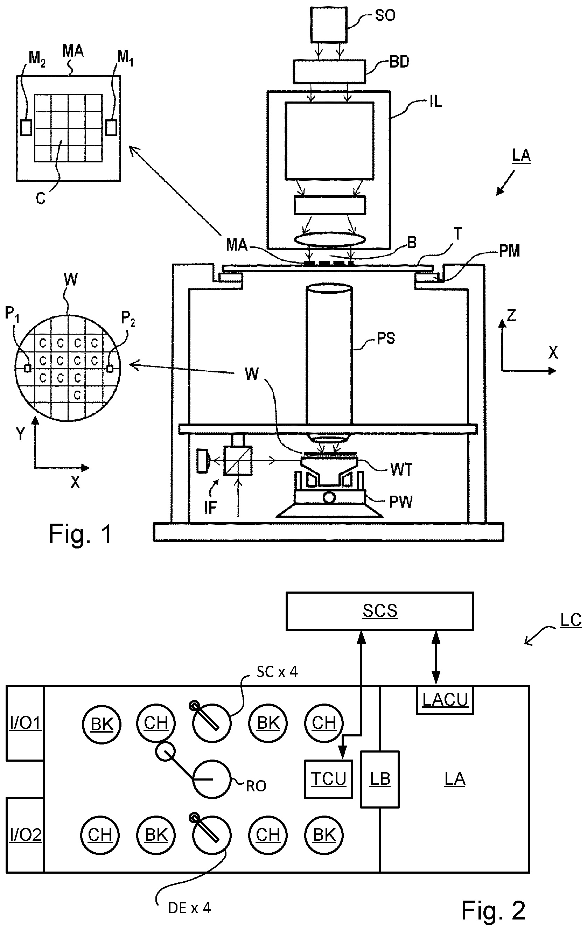

Figure 1 schematically depicts a lithographic apparatus LA or scanner (the two terms are used synonymously, although the concepts herein may also be applicable to stepper arrnagements) . The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

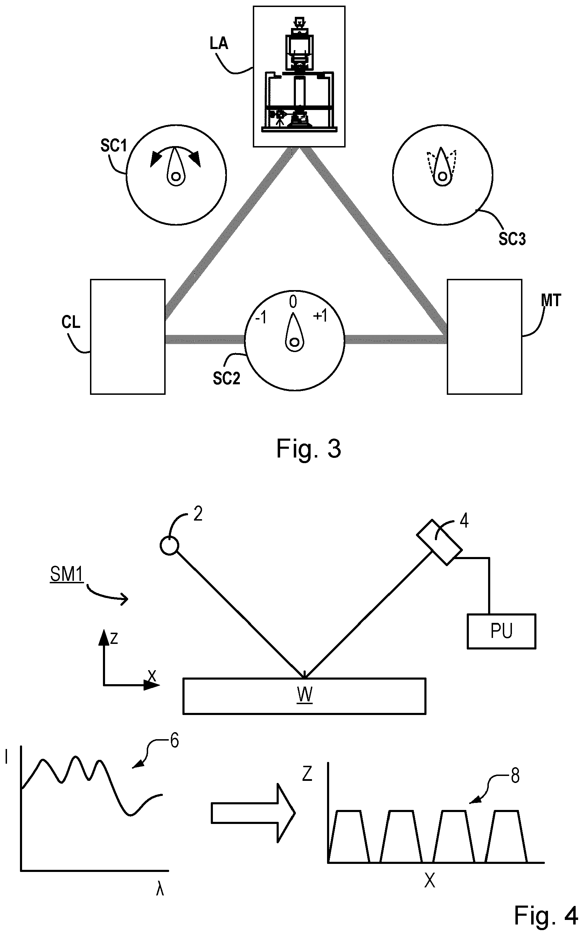

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target arrangement and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

A metrology apparatus, such as a scatterometer, is depicted in Figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

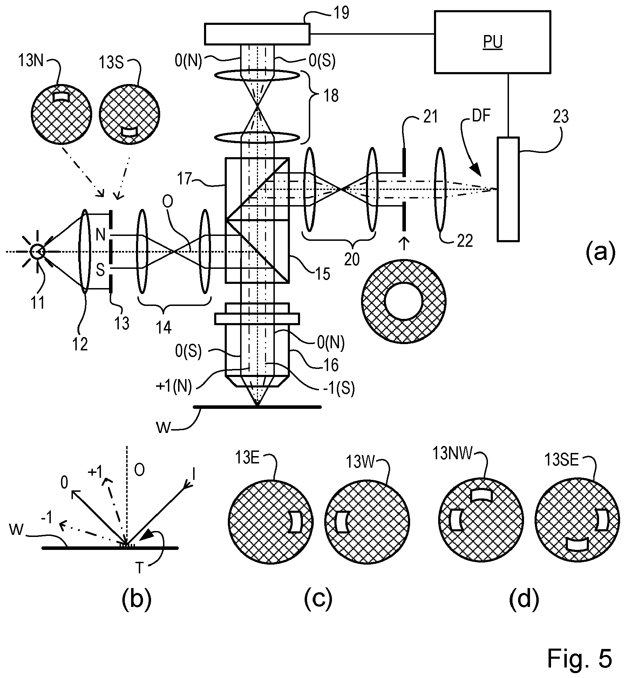

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction. The concepts disclosed herein relate to pupil measurements using this branch.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present. The particular forms of aperture plate 13 and field stop 21 shown in Figure 5 are purely examples.

When monitoring a lithographic process, it is desirable to monitor a lithographic process parameter such as focus of the lithography beam on the substrate. One known method of determining the focus setting from a printed structure is by measuring the critical dimension (CD) of the printed structure. CD is a measure of the smallest feature dimension (e.g., line width of an element). The printed structure may be a target, such as a line-space grating, formed specifically for focus monitoring. It is known that CD usually displays second order response to focus, forming what is known as a "Bossung curve" on a plot of CD against focus. A Bossung curve is a substantially symmetrical curve which is substantially symmetrical around a peak (or trough) representing the best focus. The Bossung curve may be substantially parabolic in shape.

There are several drawbacks to this approach. One drawback is that the method shows low sensitivity near best focus (due to the parabolic shape of the curve). This is typically the target focus setting for the exposure, which means that the target will be least sensitive at the target setting. Another drawback is that the method is insensitive to the sign of any defocus (as the curve is largely symmetrical around best focus). In other words, it is not possible from the target response alone, on which side of the best focus peak a CD measurement from a target represents. Additionally, this method is sensitive to *inter alia* dose crosstalk. CD is dependent on both focus and dose, and therefore any dose variation will have an impact on the CD from which focus is inferred. Any dose related CD variation will therefore cause an error in the inferred focus value.

To address these issues, diffraction based focus (DBF) was devised. Diffraction based focus may use target forming features on the reticle which print targets having a degree of asymmetry which is dependent on the focus setting during printing. This degree of asymmetry can then be measured using a scatterometry based inspection method, for example by measuring the intensity asymmetry between the intensities of + 1st and -1st order radiation diffracted from the target, to obtain a measure of the focus setting.

While DBF structures enable diffraction based focus measurements from target asymmetry, it is not suitable for use in all situations. Such structures may not comply with the strict design constraints applicable to certain product structures. During the IC manufacturing process all features on the reticle must print and stand up to subsequent processing steps. Semiconductor manufacturers use design rules as a means to restrict the feature designs to ensure the printed features conform to their process requirements. An example of such a design rule relates to the allowable size of structures or pitches. Another example design rule relates to pattern density, which may restrict the density of a resulting resist pattern to be within a particular range. Additionally the performance of DBF metrology can be insufficiently robust against lithography and/or process variations. One reason for this is that focus sensitivity is (amongst other things) driven by the sidewall angles (SWA) of the printed features, making the focus signal sensitive to the contrast of the aerial image. For EUV lithography in particular, where printing is performed using radiation of a wavelength less than 20 nm, for example 13.5 nm, the creation of sub-resolution features becomes more difficult. For EUV lithography, resist thickness, and therefore the thickness of target structures, is smaller. This weakens the diffraction efficiency of the target, and hence the signal strength, available for focus metrology.

Astigmatism based focus (ABF) is an alternative method to DBF which provides a solution for EUV focus monitoring. However, such a method requires astigmatism to be induced in the imaging lens, which means it cannot be used for on-product metrology.

To address these issues, an optical focus metrology technique will be described, which can measure a focus parameter (and optionally a dose parameter) on a target comprising at least two sub-targets: at least one non-isofocal sub-target and at least one isofocal sub-target. Each sub-target may be a simple line-space grating. The target may be suitable for on-product application. The focus parameter and dose parameter for a structure may describe the focus setting and dose setting respectively of the lithographic exposure apparatus (scanner) when exposing the structure.

As such, a method for determining a focus parameter from a target on a substrate is disclosed, the target comprising a first sub-target and second sub-target, said focus parameter relating to a focus setting of a lithographic exposure process in which said target was exposed; the method comprising: obtaining a first measurement signal relating to measurement of the first sub-target, said first sub-target comprising an isofocal structure; obtaining a second measurement signal relating to measurement of the second sub-target, said second sub-target comprising an non-isofocal structure; obtaining at least one trained relationship and/or model which relates at least said second measurement signal to said focus parameter; and determining a value for said focus parameter from said first measurement signal, second measurement signal and said at least one trained relationship and/or model.

An isofocal sub-target in the context of this disclosure is a sub-target which is formed with less than 5%, 3%, 2% or 1% variation in CD over a focus range of at least 60nm.

In an embodiment, there may be a substantial best focus shift between the at least one non-isofocal sub-target and the isofocal sub-target. Best focus may indicate a focus setting for which CD variation is minimal over a small range (e.g., +/- 5nm) around the best focus and/or a focus setting at the peak or trough of a corresponding Bossung curve for that sub-target; i.e., where CD sensitivity for small focus changes is lowest. In an embodiment, the non-isofocal sub-target should print (be exposed) at the best focus of the isofocal sub-target. Optionally the isofocal sub-target should print (be exposed) at the best focus of the non-isofocal sub-target.

In an embodiment, the best focus of the isofocal sub-target may be the same as or close to (e.g., within 20nm, within 10nm or within 5nm of) the best focus of the product structure. In an embodiment, the best focus difference between best focus of the (or each) non-isofocal target and the isofocal target (or product structure) may be greater than 40nm, greater than 50nm, be greater than 60nm, be greater than 70nm or be greater than 80nm.

Best focus for a feature may be determined in a computational lithography step such as source mask optimization (SMO). The objective of SMO is to maximize the number of patterns (and in particular critical patterns for which the process window is small) that have sufficient imaging performance such as focus margin or dose latitude for a particular illumination condition (and optimized in combination with the illumination condition). As such, the source and mask (reticle) may be optimized such that product patterns are exposed with minimal CD dependence on focus (and dose). However, this is not desirable for a focus target.

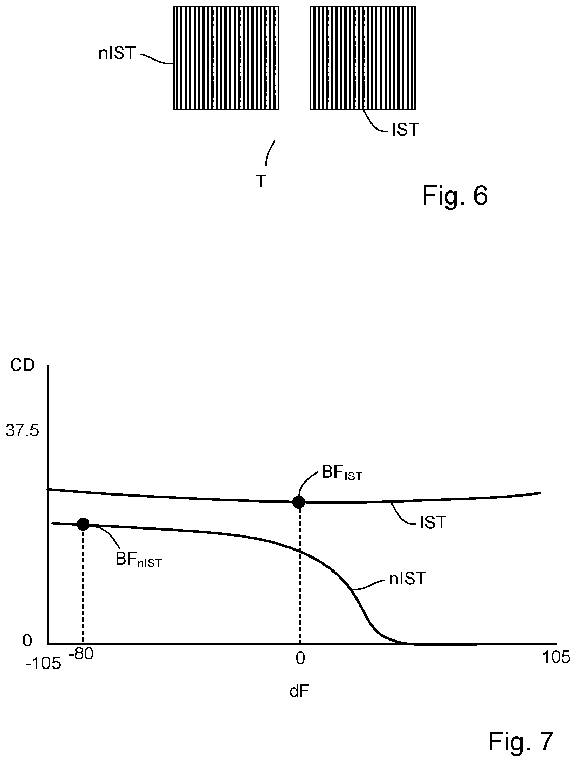

Figure 6 is an illustration of a target T according to an embodiment. The target T comprises a non-isofocal sub-target nIST and an isofocal sub-target 1ST. Each of the sub-targets nIST, 1ST may comprise line-space gratings (e.g., without assist or sub-resolution features). The best focus of each of the sub-targets nIST, 1ST may have their respective best focus tuned by varying the pitch and/or mask CD (i.e., CD of the reticle feature which forms the grating line of the sub-target); the best focus of an individual feature can be varied/tuned by modifying one or both of its pitch or mask CD. Alternatively, or in addition, the best focus shift between each of the sub-targets nIST, 1ST may result from mask 3D effects and may be obtained, for example, by using different mask absorber types including the standard Ta-based absorber, low-n absorbers with refractive index n<0.92 (and other EUV absorbers).

In an embodiment, the target may comprise more sub-targets than one non-isofocal sub-target and one isofocal sub-target. By measuring such a target with additional sub-targets, more measurement data is available, which can be beneficial for signal-to-noise ratio and/or inferring other scanner parameters than focus and dose (e.g., aberrations of the projection lens).

In an embodiment, computational lithography/SMO may be performed to determine a best focus for the product. The isofocal sub-target 1ST may then be tuned (via CD and/or pitch) to have a first best focus value which is substantially similar to that of the product structure (this may be done during SMO or subsequently). The non-isofocal sub-target nIST may then be tuned (via CD and/or pitch) to have a best focus value which is substantially different to that of the isofocal sub-target 1ST. This tuning may be done in a target optimization phase, and may be (for example) performed virtually (e.g., via computational lithography) or otherwise (e.g., by reference to known variation of best focus with pitch and/or CD, or by trial and error). As such, the non-isofocal sub-target nIST and the isofocal sub-target 1ST may differ from each other in terms of pitch and/or CD. In particular the tuning of the non-isofocal sub-target nIST may be such that the focus sensitivity around the product structures' best focus is maximized or is at least above a threshold sensitivity value (e.g., on the Bossung slope, away from the peak). Of course, it is important that the non-isofocal sub-target nIST prints at this product structure (and isofocal sub-target IST) best focus value.

By tuning the best focus value of the non-isofocal sub-target nIST sufficiently away from the peak, the variation of CD with focus of the non-isofocal sub-target nIST can be made monotonic within a range of interest, i.e., around the first best focus value and extending over a range covering any expected focus variation during exposure. Optionally a second non-isofocal sub-target nIST may be included with different focus sensitivity (e.g., tuned to have a different best focus by having a different CD and/or pitch). The CD difference of these targets should vary monotonically with focus over an even greater range.

Figure 7 is an example plot of CD against focus or defocus dF for the isofocal sub-target 1ST, and non-isofocal sub-target nIST of the target of Figure 6. The isofocal sub-target has a best focus BF_{IST} at zero defocus (e.g., best focus for the product/exposure as determined in SMO) and very little CD dependence on focus. At best focus BF_{IST}, it is apparent from the plot for the non-isofocal sub-target nIST that this non-isofocal sub-target will print. It is also apparent that this best focus value BF_{IST} corresponds with a focal range over which CD variation with focus for the non-isofocal sub-target is substantially monotonic and sensitivity is good (high gradient magnitude). The non-isofocal sub-target nIST has a best focus value BFN_{IST} separate from best focus value BF_{IST}, here specifically -80nm (i.e., 80nm difference between BF_{IST} and BF_{nIST}).

As previously stated, one problem with non-DBF focus metrology such as CD based metrology is that CD changes with both focus and dose variation and it is not straightforward to disentangle focus and dose from CD. With the target proposed herein, the isofocal sub-target can be used to isolate dose effects on CD and therefore focus inference; because this sub-target is isofocal over the focus range of interest, any CD change may be attributed to dose variation. Optionally a dose value may be determined from this target and used for dose control of the scanner exposure.

To use the proposed targets, it is proposed that one or more calibration wafers be exposed in a calibration phase, the wafers being exposed with variations in focus and dose (e.g., a focus-exposure matrix FEM). These can be inspected using a metrology tool (which may optionally for example be a tool of the type illustrated in Figure 5). Based on these measurements and known scanner settings, the variation of the measured signal (e.g., intensity or pupil spectrum) with focus can be determined, with the isofocal target used to disentangle the dose response. The calibration may comprise, for example, determining the relationship between the measured signal from the isofocal sub-target and dose (based on the known scanner dose setting) and use this in combination with the measured signal from the non-isofocal sub-target (an known scanner focus setting) to learn the relationship between the measured signal from the non-isofocal sub-target, corrected to remove dose effects on the focus inference from the non-isofocal sub-target.

The calibration may learn the direct relationship between the measured signals and focus (and dose), or alternatively may learn first the relationship between the measured signals and CD, and separately the relationship between CD and focus (and dose).

The calibration may directly model these relationships (e.g., using physics based models), or the calibration may train a data-driven model (e.g., machine learning model such as a neural network).

Following calibration, the trained/learned relationships and/or trained model may be used in a production or high volume manufacturing (HVM) setting for focus monitoring, by determining the measurement signal from both (or all) sub-targets of the target and deriving focus (and optionally dose) by application of the trained relationships and/or trained model on the measurement signals. Depending on the calibration, the focus/dose inference may be a direct inference or via CD (e.g., deriving CD of both marks from the relationships/model and measured signals and then inferring focus/dose from the derived CDs).

The metrology may comprise any suitable metrology technique, including any suitable scatterometry technique or scanning electron microscope technique. Scatterometry has the advantage of being much faster, particularly in dark-field imaging mode. The concepts disclosed herein can be implemented via dark-field scatterometry (image based) or bright-field scatterometry (e.g., pupil based).

The focus target disclosed herein may be located within a scribe lane and/or within die.

Further embodiments of the present method, computer program, non-transient computer program carrier, processing system, metrology device, lithocell, patterning device and substrate are disclosed in the subsequent list of numbered clauses:
1. A method for determining a focus parameter from a target on a substrate, the target comprising at least a first sub-target and second sub-target, said focus parameter relating to a focus setting of a lithographic exposure process in which said target was exposed; the method comprising:
   obtaining a first measurement signal relating to measurement of the first sub-target, said first sub-target comprising an isofocal structure;
   obtaining a second measurement signal relating to measurement of the second sub-target, said second sub-target comprising an non-isofocal structure;
   obtaining at least one trained relationship and/or model which relates at least said second measurement signal to said focus parameter; and
   determining a value for said focus parameter from said first measurement signal, second measurement signal and said at least one trained relationship and/or model.
2. A method as defined in clause 1, wherein said determining a value comprises determining said value for said focus parameter corrected for the effect of variation of a dose parameter on said second measurement signal.
3. A method as defined in clause 2, wherein a correction for the effect of variation of a dose parameter on said second measurement signal is determined from said first measurement signal and said at least one trained relationship and/or model.
4. A method as defined in clause 2 or 3, wherein the at least one trained relationship and/or model comprises:
   a first relationship between said second measurement signal and said focus parameter, the first relationship including a dependence on said dose parameter and a second relationship between said first measurement signal and said dose parameter; or
   a combination of said first relationship and second relationship.
5. A method as defined in clause 2 or 3, wherein the at least one trained relationship and/or model comprises:
   at least one trained machine learning model operable to infer a value for said focus parameter from said second measurement signal using said first measurement signal to correct said focus inference for said dose parameter.
6. A method as defined in any of clauses 2 to 5, comprising determining a value for said dose parameter from at least said first measurement signal and said at least one trained relationship and/or model.
7. A method as defined in any of clauses 2 to 6, comprising an initial calibration phase to train said at least one trained relationship and/or model, said initial calibration phase comprising:
   exposing multiple repetitions of said target on one or more substrates, said multiple repetitions being exposed with deliberate variation in said focus parameter and dose parameter;
   measuring said multiple repetitions of said target to obtain calibration measurement signals; and
   training said at least one trained relationship and/or model using said calibration measurement signals and known focus parameter and dose parameter settings.
8. A method as defined in clause 7, wherein said calibration measurement signals comprise first calibration measurement signals relating to the first sub-structure of each target and second calibration measurement signals relating to said the second sub-structure of each target; and
   any variation in said second calibration measurement signals is assumed to be dependent only on said dose parameter.
9. A method as defined in any preceding clause, wherein said first sub-target and said second sub-target each comprise a different best focus setting.
10. A method as defined in clause 9, wherein said first sub-target and said second sub-target comprise a different pitch and/or critical dimension.
11. A method as defined in clause 9 or 10, wherein the difference in best focus settings for said first sub-target and said second sub-target is greater than 50nm.
12. A method as defined in clause 9, 10 or 11, wherein the best focus setting for said second sub-target is such that its sensitivity to focus is maximized and/or above a threshold sensitivity when exposed at the best focus setting for said first sub-target.
13. A method as defined in any of clauses 9 to 12, wherein the best focus setting for said first sub-target is the same or close to a best focus setting for product structures to be exposed.
14. A method as defined in any preceding clause, wherein said first sub-target and said second sub-target each comprise line-space gratings.
15. A method as defined in clause 14, wherein said first sub-target and said second sub-target each comprise substantially symmetrical gratings.
16. A method as defined in any preceding clause, wherein said step of determining a value for said focus parameter comprises determining a value for the focus parameter directly from said first measurement signal, second measurement signal and said at least one trained relationship and/or model.
17. A method as defined in any of clauses 1 to 15, wherein said step of determining a value for said focus parameter comprises determining a value for critical dimension of at least said second sub-target from said first measurement signal, second measurement signal and said at least one trained relationship and/or model, and determining said focus parameter from said value for critical dimension of at least said second sub-target.
18. A method as defined in any preceding clause, wherein said target comprises at least a third sub-structure comprising a non-isofocal structure and said focus parameter is inferred from a difference of said second measurement signal and a third measurement signal from said third sub-structure.
19. A method as defined in any preceding clause, comprising measuring said target to obtain said first measurement signal and second measurement signal.
20. A method as defined in any preceding clause, comprising performing said lithographic exposure process to expose said target on said substrate using a patterning device; the method comprising:
   exposing said first sub-target from isofocal patterning features on said patterning device; and
   exposing said second sub-target from non-isofocal patterning features on said patterning device.
21. A method as defined in clause 20, wherein said isofocal patterning features have dimensions such that, with illumination settings used for said lithographic exposure process, said first sub-target has less than 3% variation in critical dimension over a focus range of at least 60nm.
22. A method as defined in clause 20 or 21, wherein said isofocal patterning features and said non-isofocal patterning features have dimensions such that, with illumination settings used for said lithographic exposure process, the first sub-target and said second sub-target each comprise a different best focus setting, and such that the said second sub-target will print successfully in an exposure at the best focus setting for said first sub-target.
23. A method as defined in clause 22, wherein said isofocal patterning features and said non-isofocal patterning features comprise dimensions such that, with illumination settings used for said lithographic exposure process, the first sub-target and said second sub-target each comprise a respective best focus setting which differs by more than 50nm.
24. A method as defined in clause 22 or 23, wherein said isofocal patterning features and said non-isofocal patterning features differ in terms of one or more of: pitch, critical dimension and mask absorber type.
25. A method as defined in clause 24, comprising optimizing said isofocal patterning features and said non-isofocal patterning features by optimizing their respective pitch and/or critical dimension to optimize said best focus settings for said first sub-target and said second sub-target.
26. A method as defined in any of clauses 22 to 25, wherein said patterning device further comprises product patterning features and said isofocal patterning features comprise dimensions such that, with illumination settings used for said lithographic exposure process, the best focus of the first sub-target is the same as or close to the best focus of the product structure formed by the product patterning features.
27. A method as defined in clause 26, wherein said non-isofocal patterning features comprise dimensions such that, with illumination settings used for said lithographic exposure process, the second sub-target has a variation in critical dimension with said focus parameter that is monotonic within a range of interest when exposed at the best focus of the product structure.
28. A method as defined in any of clauses 20 to 27, wherein neither said non-isofocal patterning features nor said isofocal patterning features comprise any sub-resolution or assist features.
29. A method as defined in any of clauses 20 to 28, wherein said isofocal patterning features and said non-isofocal patterning features are located within a scribe lane on said patterning device.
30. A method as defined in any of clauses 20 to 29, wherein said isofocal patterning features and said non-isofocal patterning features are configured to form respectively said first sub-target and said second sub-target as line-space gratings.
31. A method as defined in any of clauses 20 to 30, wherein said isofocal patterning features and said non-isofocal patterning features are configured to form respectively said first sub-target and said second sub-target as substantially symmetrical gratings.
32. A computer program comprising program instructions operable to perform the method of any of clauses 1 to 18, when run on a suitable apparatus.
33. A non-transient computer program carrier comprising the computer program of clause 32.
34. A processing system comprising a processor and a storage device comprising the computer program of clause 33.
35. A metrology device comprising the processing system of clause 34 and further operable to perform the method of clause 19.
36. A lithocell comprising:
   a lithographic exposure apparatus; and
   the metrology device of clause 35;
   wherein the lithocell is further configured to perform the method of any of clauses 20 to 31.
37. A patterning device comprising target patterning features for forming a target, the target patterning features comprising:
   isofocal patterning features for forming a first sub-target such that it comprises an isofocal structure; and
   non-isofocal patterning features for forming a second sub-target such that it comprises a non-isofocal structure.
38. A patterning device as defined in clause 37, wherein said isofocal patterning features have dimensions such that said first sub-target is formed with less than 3% variation in critical dimension over a focus range of at least 60nm.
39. A patterning device as defined in clause 37 or 38, wherein said isofocal patterning features and said non-isofocal patterning features have dimensions such that first sub-target and said second sub-target is formed with a different best focus setting, and such that the said second sub-target will print successfully in an exposure at the best focus setting for said first sub-target.
40. A patterning device as defined in clause 39, wherein said isofocal patterning features and said non-isofocal patterning features comprise dimensions such that first sub-target and said second sub-target are formed with a respective best focus setting which differs by more than 50nm.
41. A patterning device as defined in clause 39 or 40, wherein said isofocal patterning features and said non-isofocal patterning features differ in terms of one or more of: pitch, critical dimension and mask absorber type.
42. A patterning device as defined in any of clauses 39 to 41, wherein said patterning device further comprises product patterning features and said isofocal patterning features comprise dimensions such that the best focus of the first sub-target is the same as or close to the best focus of the product structure formed by the product patterning features.
43. A patterning device as defined in clause 42, wherein said non-isofocal patterning features comprise dimensions such that the second sub-target is formed with a variation in critical dimension with focus that is monotonic within a range of interest when exposed at the best focus of the product structure.
44. A patterning device as defined in any of clauses 37 to 43, wherein neither said non-isofocal patterning features nor said isofocal patterning features comprise any sub-resolution or assist features.
45. A patterning device as defined in any of clauses 37 to 44, wherein said isofocal patterning features and said non-isofocal patterning features are located within a scribe lane on said patterning device.
46. A patterning device as defined in any of clauses 37 to 45, wherein said isofocal patterning features and said non-isofocal patterning features are configured to form respectively said first sub-target and said second sub-target as line-space gratings.
47. A patterning device as defined in any of clauses 37 to 46, wherein said isofocal patterning features and said non-isofocal patterning features are configured to form respectively said first sub-target and said second sub-target as substantially symmetrical gratings.
48. A substrate comprising at least a target formed using the patterning device as defined in any of clauses 37 to 47.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method for determining a focus parameter from a target on a substrate, the target comprising at least a first sub-target and second sub-target, said focus parameter relating to a focus setting of a lithographic exposure process in which said target was exposed; the method comprising:
obtaining a first measurement signal relating to measurement of the first sub-target, said first sub-target comprising an isofocal structure;
obtaining a second measurement signal relating to measurement of the second sub-target, said second sub-target comprising an non-isofocal structure;
obtaining at least one trained relationship and/or model which relates at least said second measurement signal to said focus parameter; and
determining a value for said focus parameter from said first measurement signal, second measurement signal and said at least one trained relationship and/or model.

2. A method as claimed in claim 1, wherein said determining a value comprises determining said value for said focus parameter corrected for the effect of variation of a dose parameter on said second measurement signal.

3. A method as claimed in claim 2, wherein a correction for the effect of variation of a dose parameter on said second measurement signal is determined from said first measurement signal and said at least one trained relationship and/or model.

4. A method as claimed in claim 2 or 3, wherein the at least one trained relationship and/or model comprises:
a first relationship between said second measurement signal and said focus parameter, the first relationship including a dependence on said dose parameter and a second relationship between said first measurement signal and said dose parameter; or
a combination of said first relationship and second relationship.

5. A method as claimed in claim 2 or 3, wherein the at least one trained relationship and/or model comprises:
at least one trained machine learning model operable to infer a value for said focus parameter from said second measurement signal using said first measurement signal to correct said focus inference for said dose parameter.

6. A method as claimed in any of claims 2 to 5, comprising determining a value for said dose parameter from at least said first measurement signal and said at least one trained relationship and/or model.

7. A method as claimed in any of claims 2 to 6, comprising an initial calibration phase to train said at least one trained relationship and/or model, said initial calibration phase comprising:
exposing multiple repetitions of said target on one or more substrates, said multiple repetitions being exposed with deliberate variation in said focus parameter and dose parameter;
measuring said multiple repetitions of said target to obtain calibration measurement signals; and
training said at least one trained relationship and/or model using said calibration measurement signals and known focus parameter and dose parameter settings.

8. A method as claimed in claim 7, wherein said calibration measurement signals comprise first calibration measurement signals relating to the first sub-structure of each target and second calibration measurement signals relating to said the second sub-structure of each target; and
any variation in said second calibration measurement signals is assumed to be dependent only on said dose parameter.

9. A method as claimed in any preceding claim, wherein said first sub-target and said second sub-target each comprise a different best focus setting and/or a different pitch and/or critical dimension.

10. A method as claimed in any preceding claim, wherein said step of determining a value for said focus parameter comprises determining a value for the focus parameter directly from said first measurement signal, second measurement signal and said at least one trained relationship and/or model.

11. A method as claimed in any of claims 1 to 10, wherein said step of determining a value for said focus parameter comprises determining a value for critical dimension of at least said second sub-target from said first measurement signal, second measurement signal and said at least one trained relationship and/or model, and determining said focus parameter from said value for critical dimension of at least said second sub-target.

12. A method as claimed in any preceding claim, comprising performing said lithographic exposure process to expose said target on said substrate using a patterning device; the method comprising:
exposing said first sub-target from isofocal patterning features on said patterning device; and
exposing said second sub-target from non-isofocal patterning features on said patterning device,
wherein said isofocal patterning features and said non-isofocal patterning features differ in terms of one or more of: pitch, critical dimension and mask absorber type.

13. A metrology device comprising a processor and a storage device, the storage device comprising a computer program product, the computer program product comprising instructions operable to perform the method of any of claims 1 to 12.

14. A patterning device comprising target patterning features for forming a target, the target patterning features comprising:
isofocal patterning features for forming a first sub-target such that it comprises an isofocal structure; and
non-isofocal patterning features for forming a second sub-target such that it comprises a non-isofocal structure.

15. A substrate comprising at least a target formed using the patterning device as claimed in claim 14.
